# EUROPÄISCHE PATENTSCHRIFT

(11) **EP 2 647 041 B1**
(45) Veröffentlichungstag und Bekanntmachung des Hinweises auf die Patenterteilung: **10.12.2014**
(21) Anmeldenummer: 11775785.6
(22) Anmeldetag: 26.10.2011
(51) Int. Cl.: G01L 9/00, G01L 27/00, G01R 31/27, G01R 31/28, B81C 99/00

(54) **Verfahren und Vorrichtung zur Vermessung eines mikro-elektromechanischen Halbleiterbauteils**
Method and device for measuring a microelectromechanical semiconductor component
Procédé et dispositif de mesure d'un composant semi-conducteur micro-électromécanique

(30) Priorität: 03.12.2010 EP 10193596
(43) Veröffentlichungstag der Anmeldung: 09.10.2013
(73) Patentinhaber: ELMOS Semiconductor AG, 44227 Dortmund (DE)
(72) Erfinder: BINKHOFF, Peter, 44227 Dortmund (DE)
(74) Vertreter: Von Kreisler Selting Werner - Partnerschaft von Patentanwälten und Rechtsanwälten mbB
(86) Internationale Anmeldenummer: PCT/EP2011/068722
(87) Internationale Veröffentlichungsnummer: WO 2012/072347

(56) Entgegenhaltungen:
- US-A1- 2007 080 695
- PATIL S K ET AL: "Characterization of MEMS piezoresistive pressure sensors using AFM", ULTRAMICROSCOPY, ELSEVIER, AMSTERDAM, NL, Bd. 110, Nr. 9, 1. August 2010 (2010-08-01), Seiten 1154-1160, XP027174554, ISSN: 0304-3991 [gefunden am 2010-04-24]

## Beschreibung

Die Erfindung betrifft ein Verfahren und eine Vorrichtung zur Vermessung eines mikro-elektromechanischen Halbleiterbauteils, das ein reversibel verformbares druckempfindliches Messelement und elektronische Schaltungselemente sowie Anschlussfelder zum Abgreifen von Messsignalen aufweist.

Bei mikro-elektromechanischen Halbleiterbauteilen handelt es sich um Kleinstbauteile aus Halbleitermaterial, die sowohl mechanische als auch elektrische Funktionen aufweisen. So weisen diese Halbleiterbauteile bewegbare bzw. verformbare Elemente auf, die beispielsweise der messtechnischen Erfassung physikalischer Größen dienen können. Eine Gruppe mikro-elektromechanischer Halbleiterbauteile betrifft beispielsweise Drucksensoren, die über ein reversibel verformbares druckempfindliches Messelement zumeist in Form einer Membran verfügen. Neben einem derartigen (z.B. Mess-)Element weisen die Halbleiterbauteile elektronische Schaltungselemente sowie gegebenenfalls Auswerteschaltungen und Anschlussfelder zum Abgreifen von Messsignalen auf. Im Falle eines Drucksensors umfassen die Schaltungselemente solche, die die mechanischen Spannungen beim Verformen der Messelemente detektieren. Beispielsweise handelt es sich bei diesen Schaltelementen um druckempfindliche Transistoren oder Widerstände, die in dem Messelement integriert sind und beispielsweise in einer Brückenschaltung angeordnet sind.

Mikro-elektromechanische Halbleiterbauteile werden wie integrierte Halbleiterschaltungen auf einem Halbleitersubstrat-Wafer hergestellt. Diese Wafer werden in einem sogenannten Wafer-Prober einem Wafer-Test unterzogen; beim Test der mikro-elektromechanischen Halbleiterbauteile sind diese also noch nicht vereinzelt. Es ist bekannt, während des Wafer-Tests neben den elektrischen auch die mechanischen Funktionen der mikro-elektromechanischen Halbleiterbauteile zu testen. Im Falle von Drucksensoren wird hier beispielsweise ein Staudruckverfahren angewendet, bei dem das zu testende Halbleiterbauteil durch einen definierten Luftstrom angeblasen wird. Ferner ist es bekannt, über dem Wafer eine Druckkammer anzuordnen und den Wafer dann in dieser atmosphärischen Umgebung innerhalb der Wafer-Prober-Testanordnung zu testen. Schließlich kann man auch die Wafer-Prober-Anordnung vollständig in eine Druckkammer verbringen, um dann die Drucksensoren auf dem Wafer zu testen. In sämtlichen zuvor genannten Fällen bewirkt der von außen angelegte Druck eine Auslenkung des reversibel verformbaren Messelements, und zwar proportional zum angelegten Druck.

Aus Patil S K et al.: "Characterization of MEMS piezoresistive pressure sensors using AFM", ULTRAMICROSCOPY, ELSEVIER, AMSTERDAM, NL, Bd. 110, Nr. 9, 1. August 2010 (2010-08-01), Seiten 1154-1160, XP027174554, ISSN: 0304-3991, ist ein Testverfahren für MEMS-Drucksensoren bekannt, bei dem mittels eines Stößels auf das druckempfindliche Messelement mit einer vorgebbaren Kraft mechanisch eingewirkt wird und das dabei vom Drucksensor gelieferte Messsignal ausgewertet wird. Hierbei ist ein Kraftsensor für den Stößel erforderlich, was mit zusätzlichen Hardware-Kosten verbunden ist und eine Kalibration des Kraftsensors erfordert.

US-A-2007/0080695 beschreibt eine Testanordnung sowie ein Testverfahren für kapazitive MEMS-Sensoren mit einer bewegbaren (Kondensator-)Platte, die mechanisch bewegt wird.

Die bekannten Testverfahren für mikro-elektromechanische Halbleiterbauteile sind relativ aufwendig und erfordern eine im Vergleich zu integrierten Schaltungen nicht unbeträchtlich apparativ geänderte Wafer-Prober-Testanordnung. Außerdem unterliegen sie Einschränkungen bezüglich des Druckbereichs bzw. es müssen die Testaufbauten für verschiedene Dicken der druckempfindlichen Messelemente unterschiedlich ausgestaltet sein.

Aufgabe der Erfindung ist es, ein Verfahren und eine Vorrichtung zur Vermessung eines mikro-elektromechanischen Halbleiterbauteils zu schaffen, die über einen vereinfachten apparativen Aufbau verfügen.

Zur Lösung dieser Aufgabe wird mit der Erfindung ein Verfahren zur Vermessung eines mikro-elektromechanischen Halbleiterbauteils, das ein reversibel verformbares bezüglich mechanischer Spannungen empfindliches Messelement mit elektronischen Schaltungselementen sowie Anschlussfeldern zum Abgreifen von Messsignalen aufweist, vorgeschlagen, wobei das Verfahren die Merkmale des Anspruchs 1 aufweist.

Mit der Erfindung wird ferner auch eine Vorrichtung zur Vermessung eines mikro-elektromechanischen Halbleiterbauteils, das ein reversibel verformbares bezüglich mechanischer Spannungen empfindliches Messelement mit elektronischen Schaltungselementen sowie Anschlussfeldern zum Abgreifen von Messsignalen aufweist, vorgeschlagen, wobei die Vorrichtung versehen ist mit den Merkmalen des Anspruchs 7.

Nach der Erfindung wird das bezüglich mechanischer Spannungen empfindliche Messelement, bei dem es sich z.B. um ein druckempfindliches Messelement handelt, unter mechanischer Einwirkung mittels insbesondere eines schrittweise vorbewegbaren Stößels, bei dem es sich insbesondere um eine Nadel handelt, verformt. Nach einer bzw. nach jeder definierten schrittweisen Vorbewegung des Stößels werden die aktuell anstehenden Messsignale über die Anschlussfelder abgegriffen. Damit kann die Charakteristik des Messelements ermittelt und das Halbleiterbauteil insgesamt qualifiziert werden. Die reversible Verformbarkeit des Messelements kann darüber hinaus mit dem erfindungsgemäßen Verfahren bzw. der erfindungsgemäßen Vorrichtung, über die Geometrie des Messelements betrachtet, ortsaufgelöst durchgeführt werden, indem das Messelement in mehreren Testläufen an unterschiedlichen Stellen der mechanischen Einwirkung durch den Stößel ausgesetzt wird. Das Messelement kann z. B. ein an vier Seiten an einem Substrat angebundenes verformbares Element (Membran) sein oder aber 3-fach, 2-fach (Brücke) oder 1-fach (freitragender Balken) angebunden sein. Die Verformung kann z.B. mittels eines insbesondere piezoresistiven, für mechanische Spannungen empfindlichen Transistors oder eines Widerstands erfolgen.

Anstelle einer schrittweisen Vorbewegung des Stößels kann dieser beispielsweise auch kontinuierlich bewegt werden, wobei dann während der Verformung des Messelements in vorgebbaren zeitlichen Abständen, nämlich nach jeweils definierten unterschiedlich starken Auslenkungen des Messelements, die Messsignale ausgewertet werden. Auch auf diese Weise ist die Charakteristik des mikro-elektromechanischen Halbleiterbauteils messbar und qualifizierbar. Ebenso lässt sich durch eine kontinuierliche Verformung des Messelements auch dessen Dynamik messtechnisch erfassen, wobei zu diesem Zweck die Geschwindigkeit, mit der der Stößel vorbewegt wird, veränderbar ist. Letzteres ist aber auch bei einer schrittweisen Vorbewegung des Stößels möglich.

Als Antrieb für die schrittweise Vorbewegung des Stößels eignet sich beispielsweise ein Piezo-Linear-Motor; grundsätzlich kann aber jeder Schrittmotor oder jeder andere Motor oder allgemein jedes elektromechanische oder auch auf andere physikalische Art arbeitende Stellglied eingesetzt werden, durch den sich reproduzierbare schrittweise Vorbewegungen realisieren lassen.

Wie bereits oben erwähnt, kann der Stößel als Nadel ausgebildet sein. Auch ein Wafer-Prober arbeitet mit (Abtast- bzw. Abgriff-)Nadeln, mit denen die Anschlussfelder einer Halbleiterschaltung abgegriffen werden. Das erfindungsgemäße Verfahren lässt sich damit in einen Wafer-Prober integrieren. Die das reversibel verformbare Messelement auslenkende Nadel besteht dabei beispielsweise aus Keramik, Glasfaser, Kunststoff, Wolfram oder einem anderen Material. Das das Messelement kontaktierende Ende des Stößels bzw. der Nadel sollte gerundet sein.

Mit der Erfindung ist es möglich, mikro-elektromechanische Halbleiterbauteile (beispielsweise Drucksensoren) bezüglich ihrer Linearität, ihrer Empfindlichkeit, ihrer Temperaturabhängigkeit, ihrer Reversibilität, bezüglich ihrer Hysterese und/oder daraufhin zu untersuchen, ob bei diesen Halbleiterbauteilen überhaupt ein Messelement vorhanden ist und ob dieses Messelement mechanisch korrekt an den Rest des Halbleiterbauteils angebunden ist. Allgemein lässt sich also mit der Erfindung die Charakteristik eines mikro-elektromechanischen Halbleiterbauteils ermitteln und das Halbleiterbauteil selbst mechanisch vermessen. Entscheidend für die Erfindung ist, dass nicht die Kraft, mit der das Messelement durch den Stößel verformt wird, sondern der Weg, um den das Messelement durch den Stößel ausgelenkt und damit verformt wird, vorgegebenen wird und damit die Weg/Kraft- bzw. durch Umrechnung die Weg/Druck-Kennlinie des MEMS-Sensors vermessen und zu Zwecken der Qualifizierung des Bauteils gewählt wird.

Wie bereits oben erwähnt, kann es sich bei dem mikro-elektromechanischen Halbleiterbauteil um einen Drucksensor handeln. Ein nach der Erfindung zu vermessendes mikro-elektromechanisches Halbleiterbauteil kann aber auch als Beschleunigungssensor oder Viskositätssensor eingesetzt werden. Grundsätzlich kann mit der Erfindung jedwedes mikro-elektromechanische Halbleiterbauteil in jeder denkbaren Applikation getestet werden.

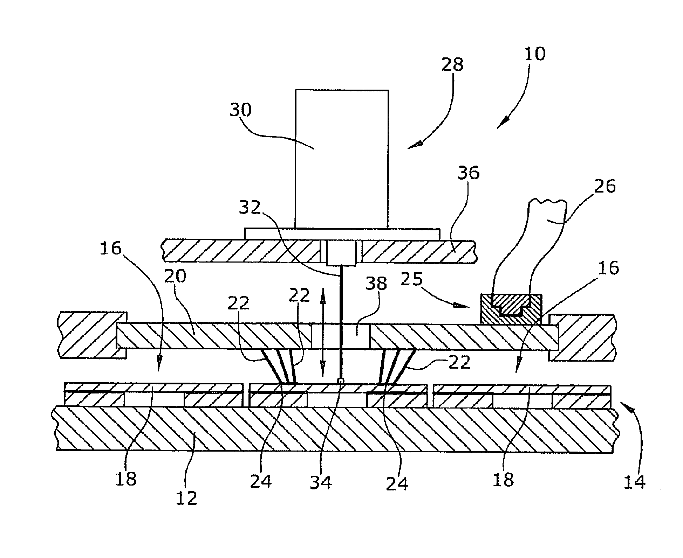

Die Erfindung wird nachfolgend anhand der Zeichnung näher erläutert.

In der Zeichnung ist schematisch der Testaufbau für einen Wafer-Prober 10 gezeigt, der einen Träger 12 für einen beispielsweise Silizium-Wafer 14 aufweist, in dem eine Vielzahl von mikro-elektromechanischen Halbleiterbauteil-Drucksensoren 16 ausgebildet sind. Jeder Drucksensor 16 weist dabei beispielsweise eine Membran 18 als reversibel verformbares, für mechanische Spannungen empfindliches, in diesem Fall z.B. druckempfindliches Messelement auf. Der Wafer-Prober 10 verfügt darüber hinaus über einen Träger 20 mit Testnadeln 22 zum Kontaktieren von Anschlussfeldern 24 der Drucksensoren 16. Darüber hinaus kann dieser Träger 20 beispielsweise elektronische Bauteile oder Schaltungen und einen Anschluss 25 für eine zu einer Testsignalauswerteschaltung führende Verkabelung 26 aufweisen.

Erfindungsgemäß wird nun ein derartiger Wafer-Prober 10 modifiziert, indem ein Stellglied 28 in Form beispielsweise eines Piezo-Linear-Motors 30 zur schrittweisen oder kontinuierlichen Vor- und Zurückbewegung eines der mechanischen Auslenkung der Drucksensor-Membranen 18 dienenden nadelförmigen Stößels 32 vorgesehen wird. Der nadelförmige Stößel 32 weist eine gerundete Spitze 34 auf, die beispielsweise als Mikrokugel ausgebildet sein kann. Zur Halterung des Stellgliedes 28 dient ein weiterer Träger 36, der oberhalb des Trägers 20 für die Nadeln 22 angeordnet sein kann. Der nadelförmige Stößel 32 erstreckt sich dann durch eine Öffnung 38 dieses Trägers 20 hindurch, ist also somit im Wesentlichen zentrisch zu den (elektrischen) Nadeln 22 angeordnet.

Überraschenderweise hat sich gezeigt, dass trotz der mechanischen Einwirkung auf die Membranen 18 durch Kontaktierung derselben mittels des nadelförmigen Stößels 32 keinerlei die Funktionalität der Membranen 18 beeinträchtigenden Beschädigungen an den Drucksensoren 16 durch den erfindungsgemäßen Test auftreten. Die Erfindung hat unter anderem den weiteren Vorteil, dass der gleiche Testaufbau für verschiedene Membrandicken verwendet werden kann, so dass insoweit keinerlei Einschränkungen für den Testdruckbereich gegeben sind. Die bei den unterschiedlich starken mechanischen Auslenkungen der Membranen 18 ermittelten Messwerte können mit einem entsprechenden Luftdruck korreliert werden. Damit kann insgesamt das Halbleiterbauteil qualifiziert werden. Beim erfindungsgemäßen mechanischen Test des verformbaren Elements kann dieses den gleichen Verformungen wie beim späteren Einsatz ausgesetzt werden. Insbesondere lassen sich somit beim Testen die gleichen Bedingungen wie bei der bestimmungsgemäßen Verwendung des Bauteils simulieren. Dies ist bei den bisher bekannten Testverfahren kaum möglich, da sich z.B. Drücke von mehreren 10 bis 100 bar beim Testen nicht bzw. nur mit extremem Aufwand realisieren lassen.

## Patentansprüche

1. Verfahren zur Vermessung eines mikro-elektromechanischen Halbleiterbauteils, das ein reversibel verformbares bezüglich mechanischer Spannungen empfindliches Messelement mit elektronischen Schaltungselementen sowie Anschlussfeldern zum Abgreifen von Messsignalen aufweist, wobei bei dem Verfahren
- das Messelement (18) des Halbleiterbauteils (16) zur Ermittlung seiner Weg/Kraft- bzw. Weg/Druck-Kennlinie durch mechanische Einwirkung mittels eines vorbewegbaren Stößels (32) zunehmend verformt wird,
**dadurch gekennzeichnet,**
- **dass** die Größe der Wegstrecke vorgegeben wird, um die der Stößel (32) bei Anlage an dem Messelement (18) des Halbleiterbauteils (16) vorbewegt wird,
- **dass** nach dem Zurücklegen jeweils vorgegebener Wegstrecken durch den Stößel (32) über die Anschlussfelder (24) des Halbleiterbauteils (16) die jeweils aktuellen Messsignale abgegriffen werden und
- **dass** das Halbleiterbauteil (16) anhand der gewonnenen, die Weg/Kraft- bzw. Weg/Druck-Kennlinie repräsentierenden Messsignale qualifiziert wird.

2. Verfahren nach Anspruch 1, **dadurch gekennzeichnet, dass** eine Vielzahl von zu vermessenden Halbleiterbauteilen (16) auf einem Substrat-Wafer (14) ausgebildet sind und dass die Vermessung im Rahmen eines Wafer-Tests durchgeführt wird.

3. Verfahren nach Anspruch 1, **dadurch gekennzeichnet, dass** das Halbleiterbauteil (16) in einem Gehäuse untergebracht ist, wenn es getestet wird.

4. Verfahren nach einem der Ansprüche 1 bis 3, **dadurch gekennzeichnet, dass** die Vermessung in einer Testvorrichtung (10) zum Testen der elektronischen Schaltung des Halbleiterbauteils (16) durchgeführt wird.

5. Verfahren nach einem der Ansprüche 1 bis 4, **dadurch gekennzeichnet, dass** als Stößel (32) eine Testnadel mit gerundeter Spitze (34) gewählt wird.

6. Verfahren nach einem der Ansprüche 1 bis 5, **dadurch gekennzeichnet, dass** der Stößel (32) schrittweise um jeweils ein vorgebbares Wegmaß weiter vorbewegt wird.

7. Vorrichtung zur Vermessung eines mikro-elektromechanischen Halbleiterbauteils, das ein reversibel verformbares bezüglich mechanischer Spannungen empfindliches Messelement mit elektronischen Schaltungselementen sowie Anschlussfeldern zum Abgreifen von Messsignalen aufweist, mit
- mehreren elektrischen Testnadeln (22) zum elektrischen Kontaktieren der Anschlussfelder (24) des Halbleiterbauteils (16) und
- einem vor- und zurückbewegbaren Stößel (32) zur mechanischen Kontaktierung des Messelements (18),
**gekennzeichnet durch**
- ein Stellglied zum weggesteuerten Bewegen des Stößels (32) um jeweils ein vorgegebenes Wegmaß für eine zunehmende Verformung des Messelements (18).

8. Vorrichtung nach Anspruch 7, **dadurch gekennzeichnet, dass** der Stößel (32) schrittweise weggesteuert bewegbar ist.

## Claims

1. A method for measuring a microelectromechanical semiconductor component comprising a reversibly deformable measuring element sensitive to mechanical stresses, said measuring element being provided with electronic circuit elements as well as terminal pads for tapping measurement signals, wherein in the method
- said measuring element (18) of said semiconductor component (16), for the purpose of determining the distance/force and respectively distance/pressure characteristic curve thereof, is increasingly deformed by mechanical action of a plunger (32) which can be advanced,
**characterized in**
- **that** the amount of the distance of the advancement of the plunger (32) when in abutment on the measuring element (18) of the semiconductor component (16), is predetermined,
- **that**, after an advancing movement of the plunger (32) by respective predetermined distances, the respective current measurement signals are tapped via the terminal pads (24) of the semiconductor component (16), and
- the semiconductor component (16) is qualified on the basis of the obtained measurement signals representing the distance/force and respectively distance/pressure characteristic curve.

2. The method according to claim 1, **characterized in that** a plurality of semiconductor components (16) to be measured are configured on a substrate wafer (14), and that the measurement is carried out within the framework of a wafer test.

3. The method according to claim 1, **characterized in that** the semiconductor component (16) is accommodated in a housing when being tested.

4. The method according to any one of claims 1 to 3, **characterized in that** the measurement is carried out in a test device (10) for testing the electronic circuit of the semiconductor component (16).

5. The method according to any one of claims 1 to 4, **characterized in that**, as the plunger (32), a test needle having a rounded point (34) is selected.

6. The method according to any one of claims 1 to 5, **characterized in that** the plunger (32) is advanced in a step-wise manner by a respective predeterminable distance amount.

7. A device for measuring a microelectromechanical semiconductor component which comprises a reversibly deformable measuring element sensitive to mechanical stresses, said measuring element being provided with electronic circuit elements as well as terminal pads for tapping measurement signals, said device including
- a plurality of electric test needles (22) for electrically contacting the terminal pads (24) of said semiconductor component (16),
- a plunger (32) adapted to be moved forward and backward for mechanically contacting the measuring element (18),
**characterized by**
- an actuator for moving the plunger (32) in a distance-controlled manner by a respective predetermined distance amount to increasingly deform said measuring element (18).

8. The method according to claim 7, **characterized in that** the plunger (32) is moveable in a stepwise, distance-controlled manner.

## Revendications

1. Procédé de mesure d'un composant semi-conducteur micro-électromécanique qui présente un élément de mesure à déformation réversible, sensible aux contraintes mécaniques, pourvu d'éléments de circuit électroniques ainsi que de panneaux de connexion pour capter des signaux de mesure, procédé dans lequel
- l'élément de mesure (18) du composant semi-conducteur (16) est déformé de manière croissante par action mécanique au moyen d'un coulisseau (32) pouvant être déplacé en avant pour déterminer sa caractéristique course/force ou course/pression,
**caractérisé en ce que**
- la grandeur de la distance de laquelle le coulisseau (32) est déplacé en avant au contact de l'élément de mesure (18) du composant semi-conducteur (16) est prédéterminée,
- après que le coulisseau (32) a parcouru des distances respectivement prédéterminées, les signaux de mesure en cours sont captés via les panneaux de connexion (24) du composant semi-conducteur (16), et
- le composant semi-conducteur (16) est qualifié à l'aide des signaux de mesure obtenus représentant la caractéristique course/force ou course/pression.

2. Procédé selon la revendication 1, **caractérisé en ce qu'**une pluralité de composants semi-conducteurs (16) à mesurer sont formés sur une tranche de substrat (14) et **en ce que** la mesure est réalisée dans le cadre d'un test sur tranche.

3. Procédé selon la revendication 1, **caractérisé en ce que** le composant semi-conducteur (16) est logé dans un boîtier lorsqu'il est testé.

4. Procédé selon l'une des revendications 1 à 3, **caractérisé en ce que** la mesure est effectuée dans un dispositif de test (10) destiné à tester le circuit électronique du composant semi-conducteur (16).

5. Procédé selon l'une des revendications 1 à 4, **caractérisé en ce que** le coulisseau (32) choisi est une sonde à aiguille à pointe arrondie (34).

6. Procédé selon l'une des revendications 1 à 5, **caractérisé en ce que** le coulisseau (32) est déplacé pas à pas plus en avant d'une valeur de course prédéterminable.

7. Dispositif pour la mesure d'un composant semi-conducteur micro-électromécanique qui présente un élément de mesure à déformation réversible, sensible aux contraintes mécaniques, pourvu d'éléments de circuit électroniques ainsi que de panneaux de connexion pour capter des signaux de mesure, comprenant
- plusieurs sondes à aiguille (22) électriques pour établir le contact électrique entre les tableaux de connexion (24) du composant semi-conducteur (16), et
- un coulisseau (32) apte à être déplacé en avant et en arrière pour établir le contact mécanique avec l'élément de mesure (18),
**caractérisé par**
- un actionneur pour le déplacement à course commandée du coulisseau (32) d'une valeur de course prédéterminée pour une déformation croissante de l'élément de mesure (18).

8. Dispositif selon la revendication 7, **caractérisé en ce que** le coulisseau (32) est déplaçable pas à pas avec commande de la course.
